# EUROPEAN PATENT APPLICATION

(11) **EP 4 796 550 A1**
(43) Date of publication of application: **26.08.2026**
(21) Application number: 25160048.2
(22) Date of filing: 25.02.2025
(51) Int. Cl.: C07F 7/30, C07H 23/00, G03F 7/031

(54) **NOVEL ACYL GERMANIUM AND ACYL TIN COMPOUNDS, THEIR SYNTHESIS AND USES THEREOF**

(71) Applicant: Technische Universität Graz, 8010 Graz (AT)
(72) Inventor: HAAS, Michael, 8051 GRAZ (AT); PARIS, Matthias, 8020 GRAZ (AT); GESCHEIDT-DEMNER, Georg, 8020 GRAZ (AT); RAPTOVA, Renáta, 8043 GRAZ (AT)
(74) Representative: Lavoix

(57) **Abstract**

The present invention relates to a represented by the following general formula (I), a method of preparing the compound, a composition containing the compound and uses of the compound: 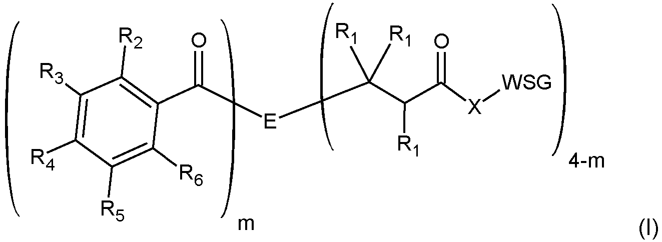 wherein
E represents Ge or Sn;
R₁ represents - independently from each other on each occurrence - hydrogen or an alkyl group;
R₂, R₃, R₄, R₅, R₆ represent - independently from each other on each occurrence - -H, -F, -Cl, -OR₇, -SR₇, -N(R₇)₂, -CF₃, -CN, -NO₂, -COOR₇, -CONHR₇, a branched, cyclic or preferably linear C₁₋₂₀ alkyl, C₂₋₂₀ alkenyl, C₁₋₂₀ alkyloxy or a C₂₋₂₀ alkenoxy moiety, optionally interrupted one or more times by O, S or -NR₇- and optionally substituted by one or more polymerizable groups and/or moieties R₇;
R₇ represents - independently from each other on each occurrence - hydrogen or a branched, cyclic or preferably linear C₁₋₂₀ alkyl or C₂₋₂₀ alkenyl moiety;
X represents - independently from each other on each occurrence - a single bond or a divalent group selected from the group consisting of -O-, -N(-H)- or -N(-WSG)-;
WSG represents - independently from each other on each occurrence - a watersoluble group selected from a carbohydrate, an amino acid, or a polyethylene glycol (PEG) group;
m represents 2 or 3.

## Description

### FIELD OF THE INVENTION

The present invention relates to acyl germanium and acyl tin compounds which are suitable, among others, as photoinitiators for curing radically or cationically polymerizable materials and/or as phototherapeutics. The compounds are characterized in that they can be activated at specific wavelengths and even by visible light, they exhibit good solubility in polar solvents, such as water and alcohols, which is important in terms of environmental aspects and sustainability, and high stability in common resin systems.

### BACKGROUND

Radical polymerization reactions are used in many industrial processes, such as 3D printing. Besides thermal initiators, photoinitiators are conventionally used for initiating the polymerization reactions in 3D printing. The design and a most efficient synthesis of the photoinitiators are in the focus of new developments. New photoinitiators must be able to be activated at certain wavelengths. Water solubility is a particularly important aspect, not least because of the need for sustainable and environmentally friendly production processes.

Various classes of compounds are commonly used as photoinitiators, among them acyl germanium and acyl tin compounds, also referred to as acylgermanes and acylstannanes, respectively. In particular acylgermanes may undergo a Norrish Type I cleavage when irradiated, which means that when irradiated in the region of their n-π* transition in the near ultraviolet, they undergo an α-cleavage from the exited triplet state resulting in the formation of a germanium-centered and a carbon-centered radical. Various acyl germanium and acyl tin compounds and their use as photoinitiators are described in EP 1 905 415 A1, EP 3 868 767 A1, EP 3 303 415 B1, WO 2020/117513 A2 and EP 3 124 509 A1.

Commercially available bisacylgermanes, such as bis(4-methoxybenzoyl)diethyl germanium (Ivocerin^{®}, available from Ivoclar Vivadent) or tetraacylgermanes, such as tetrakis(2-methylbenzoylgermane), suffer from the disadvantage of poor solubility in water and other polar media as well as in many important monomers (Haas, M.; Radebner, J.; Eibel, A.; Gescheidt, G.; Stueger; H., Recent Advances in Germanium-Based Photoinitiator Chemistry. Chemistry - A European Journal 2018, 24 (33), 8258-8267). Ivocerin^{®} has the further disadvantage of a complex production (e.g. purification) and the resulting high costs (US 10,787,468 B2).

Thus, there is still room for improvements with regard to acyl germanium and acyl tin compounds, particularly when used as a photoinitiator but also for other purposes. In particular, there is a need for acyl germanium and acyl tin compounds having good solubility in water and other polar solvents as well as in a polar resin composition and which may be synthesized in a clean and cost-efficient manner.

### OBJECT OF THE INVENTION

In light of the foregoing, the present invention aims at overcoming the above described problems and drawbacks. Thus, an object of the present invention is to provide acyl germanium and acyl tin compounds having good solubility in water and other polar solvents, as well as in a polar resin compositions and which may be synthesized in a clean and cost-efficient manner. Moreover, it is desired that acyl germanium and acyl tin compounds, in particular when used as photoinitiators, may be activated at specific wavelengths, preferably even by visible light.

### SUMMARY OF THE INVENTION

The present inventors have made diligent studies for solving this object and have found that water-soluble bis- and tris-acyl germanium and tin compounds previously considered as non-synthesisable can be obtained by Michael addition of bis- and tris-acylgermane and stannane precursors with an α,β-unsaturated carbonyl compound bearing a water soluble group. Moreover, such synthesis method is efficient and clean and does in particular not require the use of expensive purification methods, thus also being advantageous in terms of costs and sustainability. The bis- and tris-acyl germanium and tin compounds thus obtained show significant activity as photoinitiators for radical polymerisation, as demonstrated in corresponding experiments. The compounds absorb in the long-wavelength range and therefore act as highly effective photoinitiators when irradiated with visible light. This makes them very competitive - also in comparison to Ivocerin^{®} (state of the art photoinitiator, not water-soluble). High absorption in the tail-out and good photobleaching may be observed. Due to their excellent quantum yield, they are effective at even low concentration. In addition, the compounds are characterised by a particularly good solubility in polar media (e.g. water and various alcohols) and stability in conventional resin systems.

Accordingly, the present invention relates to a compound represented by the following general formula (I): 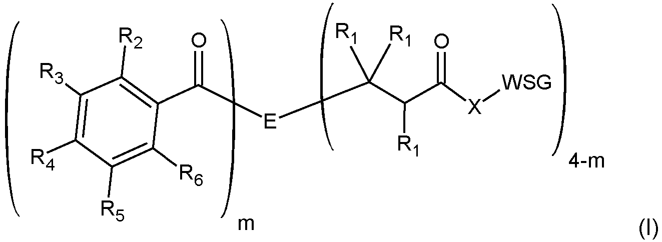 wherein
E represents Ge or Sn;
R₁ represents - independently from each other on each occurrence - hydrogen or an alkyl group;
R₂, R₃, R₄, R₅, R₆ represent - independently from each other on each occurrence - -H, -F, -Cl, -OR₇, -SR₇, -N(R₇)₂, -CF₃, -CN, -NO₂, -COOR₇, -CONHR₇, a branched, cyclic or preferably linear C₁₋₂₀ alkyl, C₂₋₂₀ alkenyl, C₁₋₂₀ alkyloxy or a C₂₋₂₀ alkenoxy moiety, optionally interrupted one or more times by O, S or -NR₇- and optionally substituted by one or more polymerizable groups and/or moieties R₇;
R₇ represents - independently from each other on each occurrence - hydrogen or a branched, cyclic or preferably linear C₁₋₂₀ alkyl or C₂₋₂₀ alkenyl moiety;
X represents - independently from each other on each occurrence - a single bond or a divalent group selected from the group consisting of -O-, -N(-H)- or -N(-WSG)-;
WSG represents - independently from each other on each occurrence - a water-soluble group selected from a carbohydrate, an amino acid, or a polyethylene glycol (PEG) group;
m represents 2 or 3.

The present invention further relates to method of preparing (synthesizing) a compound, in particular a compound as described herein, the method comprising reacting a precursor compound represented by the following general formula (VI) with an α,β-unsaturated carbonyl compound represented by the following general formula (VII) under alkaline conditions (to yield a compound as described herein). 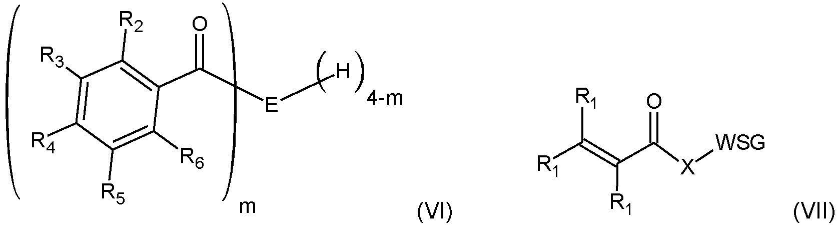 wherein
E represents Ge or Sn; R₁ represents - independently from each other on each occurrence - hydrogen or an alkyl group;
R₂, R₃, R₄, R₅, R₆ represent - independently from each other on each occurrence - -H, -F, -Cl, -OR₇, -SR₇, -N(R₇)₂, -CF₃, -CN, -NO₂, -COOR₇, -CONHR₇, a branched, cyclic or preferably linear C₁₋₂₀ alkyl, C₂₋₂₀ alkenyl, C₁₋₂₀ alkyloxy or a C₂₋₂₀ alkenoxy moiety, optionally interrupted one or more times by O, S or -NR₇- and optionally substituted by one or more polymerizable groups and/or moieties R₇;
R₇ represents - independently from each other on each occurrence - hydrogen or a branched, cyclic or preferably linear C₁₋₂₀ alkyl or C₂₋₂₀ alkenyl moiety;
X represents - independently from each other on each occurrence - a single bond or a divalent group selected from the group consisting of -O-, -N(-H)- or -N(-WSG)-;
WSG represents - independently from each other on each occurrence - a water-soluble group selected from a carbohydrate, an amino acid, or a polyethylene glycol (PEG) group;
m represents 2 or 3.

Moreover, the present invention relates to a composition comprising a compound as described herein and at least one (photo)polymerizable monomer, oligomer and/or prepolymer.

Still further, the present invention relates to the use of a compound as described herein as a photoinitiator (in particular for a radical or cationic photopolymerization reaction).

Furthermore, the present invention relates to a method of preparing polymers, the method comprising irradiating a composition (as described herein) comprising at least one (photo)polymerizable monomer, oligomer and/or prepolymer and a compound as described herein as a photoinitiator at a wavelength of from 320 to 470 nm.

Still further, the present invention relates to the use of a compound as described herein as a phototherapeutic. In other words, the present invention relates a compound as described herein for use as a phototherapeutic.

Other objects and many of the attendant advantages of embodiments of the present invention will be readily appreciated and become better understood by reference to the following detailed description of embodiments.

### DETAILED DESCRIPTION OF THE INVENTION

Hereinafter, details of the present invention and other features and advantages thereof will be described. However, the present invention is not limited to the following specific descriptions, but they are rather for illustrative purposes only.

It should be noted that features described in connection with one exemplary embodiment or exemplary aspect may be combined with any other exemplary embodiment or exemplary aspect, in particular features described with any exemplary embodiment of a compound may be combined with any exemplary embodiment of a method of preparing, a composition, a use, and vice versa, unless specifically stated otherwise.

Where an indefinite or definite article is used when referring to a singular term, such as "a", "an" or "the", a plural of that term is also included and vice versa, unless specifically stated otherwise, whereas the word "one" or the number "1", as used herein, typically means "just one" or "exactly one".

The expression "comprising", as used herein, includes not only the meaning of "comprising", "including" or "containing", but may also encompass "consisting essentially of" and "consisting of".

Unless specifically stated otherwise, the expressions "at least partially", "at least a partial" or "at least a part of", as used herein, may mean at least 5 % thereof, in particular at least 10 % thereof, in particular at least 15 % thereof, in particular at least 20 % thereof, in particular at least 25 % thereof, in particular at least 30 % thereof, in particular at least 35 % thereof, in particular at least 40 % thereof, in particular at least 45 % thereof, in particular at least 50 % thereof, in particular at least 55 % thereof, in particular at least 60 % thereof, in particular at least 65 % thereof, in particular at least 70 % thereof, in particular at least 75 % thereof, in particular at least 80 % thereof, in particular at least 85 % thereof, in particular at least 90 % thereof, in particular at least 95 % thereof, in particular at least 98 % thereof, and may also mean 100 % thereof.

In a first aspect, the present invention relates to a compound represented by the following general formula (I): 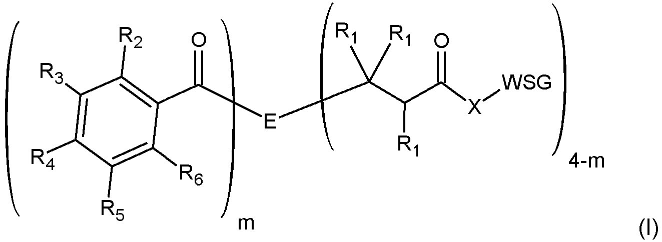 wherein
E represents Ge or Sn;
R₁ represents - independently from each other on each occurrence - hydrogen or an alkyl group;
R₂, R₃, R₄, R₅, R₆ represent - independently from each other on each occurrence - -H, -F, -Cl, -OR₇, -SR₇, -N(R₇)₂, -CF₃, -CN, -NO₂, -COOR₇, -CONHR₇, a branched, cyclic or preferably linear C₁₋₂₀ alkyl, C₂₋₂₀ alkenyl, C₁₋₂₀ alkyloxy or a C₂₋₂₀ alkenoxy moiety, optionally interrupted one or more times by O, S or -NR₇- and optionally substituted by one or more polymerizable groups and/or moieties R₇;
R₇ represents - independently from each other on each occurrence - hydrogen or a branched, cyclic or preferably linear C₁₋₂₀ alkyl or C₂₋₂₀ alkenyl moiety;
X represents - independently from each other on each occurrence - a single bond or a divalent group selected from the group consisting of -O-, -N(-H)- or -N(-WSG)-;
WSG represents - independently from each other on each occurrence - a water-soluble group selected from a carbohydrate, an amino acid, or a polyethylene glycol (PEG) group;
m represents 2 or 3.

More specifically, the present invention relates to an acyl germanium compound (in case of E representing Ge) or an acyl tin compound (in case of E representing Sn), which may also be referred to as an acylgermane and an acylstannane, respectively.

In a preferred embodiment, E represents Ge. In another embodiment, E represents Sn.

The meaning of the terms "linear", "branched", "cyclic", "saturated", "unsaturated" and "unsubstituted", as used herein, corresponds to the respective well-established meanings thereof, as known to a person skilled in the art. The term "substituted", as used herein, means that one or more, in particular 1, 2, 3, 4, 5, 6, 7, 8, 9 or 10, hydrogen atom(s) of the respective groups are substituted by a substituent. Examples of suitable substituents, include halogen atoms, such as -F, -Cl, -Br, -I; -OH, hydroxyalkyl groups (ether), -SH, thioalkyl groups (thioether), =O, carboxyl groups (-COOH) and salts, esters and amides thereof, -NH₂, secondary amine groups, tertiary amine groups, nitrile groups and nitro groups. If two or more substituents are present, they may be the same or different and they may be bound to each other to form a ring. In particular, the substituent may also be a polymerizable group and/or R₇.

The term "alkyl", as used herein, refers to, whether it is used alone or as part of another group, linear or branched, saturated alkyl groups. Suitable examples of the alkyl group include C₄ to C₂₀ alkyl groups, in particular C₂ to C₁₀ alkyl groups, in particular C₃ to C₈ alkyl groups, in particular C₄ to C₆ alkyl groups, but may in particular include a methyl group.

The term "alkyloxy", as used herein, refers to, whether it is used alone or as part of another group, linear or branched, saturated alkyl groups further comprising at least one oxygen atom which may interrupt the alkyl chain and/or form an ether functional group with the carbon atom bearing the alkyoxy group. Suitable examples of the alkyoxy group include C₁ to C₂₀ alkyoxy groups, in particular C₂ to C₁₀ alkyloxy groups, in particular C₃ to C₈ alkyloxy groups, in particular C₄ to C₆ alkyloxy groups, but may in particular include a methoxy group or ethoxy group.

The term "alkenyl", as used herein, refers to, whether it is used alone or as part of another group, linear or branched-chain, unsaturated alkenyl groups. Suitable examples of the alkenyl group include C₂ to C₂₀ alkenyl groups, in particular C₂ to C₁₀ alkenyl groups, in particular C₃ to C₈ alkenyl groups, in particular C₄ to C₆ alkenyl groups. The alkenyl group comprises at least one double bond, such as 1, 2 or 3 double bonds.

The term "alkenoxy", as used herein, refers to, whether it is used alone or as part of another group, linear or branched, unsaturated alkenyl groups further comprising at least one oxygen atom which may interrupt the alkenyl chain and/or form an ether functional group with the carbon atom bearing the alkenoxy group. Suitable examples of the alkenoxy group include C₁ to C₂₀ alkenoxy groups, in particular C₂ to C₁₀ alkenoxy groups, in particular C₃ to C₈ alkenoxy groups, in particular C₄ to C₆ alkenoxy groups. The alkenoxy group comprises at least one double bond, such as 1, 2 or 3 double bonds.

The term "water-soluble group", as used herein, may in particular denote a polar group increasing the water-solubility of the compound, in particular rendering the compound water-soluble. To this end, the water-soluble group may exhibit a polarity with a(n) (electrical) dipole moment of at least 3 x 10⁻³⁰ C·m. Suitable examples of the water-soluble group include a carbohydrate, an amino acid, or a polyethylene glycol (PEG) group.

In an embodiment, R₁ represents - independently from each other on each occurrence - hydrogen or a methyl group. In particular, the R₁ in α position to the carbonyl group may represent - independently from each other on each occurrence - hydrogen or a methyl group.

In an embodiment, R₂, R₃, R₄, R₅, R₆ represent - independently from each other on each occurrence - hydrogen, a methyl group, a methoxy group. In other words, the aromatic moiety in the compound may represent a mesityl group.

In an embodiment, X represents - independently from each other on each occurrence - a single bond. In other words, the compound may be represented by the following general formula (II): 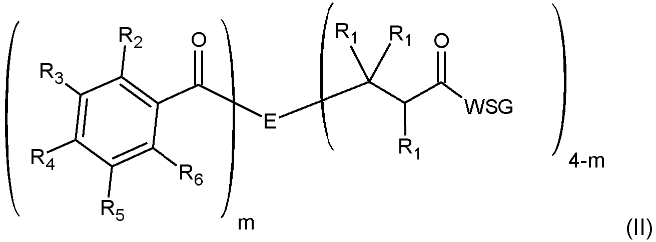 wherein E, R₁, R₂, R₃, R₄, R₅, R₆, WSG and m are defined as above.

In an embodiment, X represents independently from each other on each occurrence "-O-". In other words, the compound may be represented by the following general formula (III): 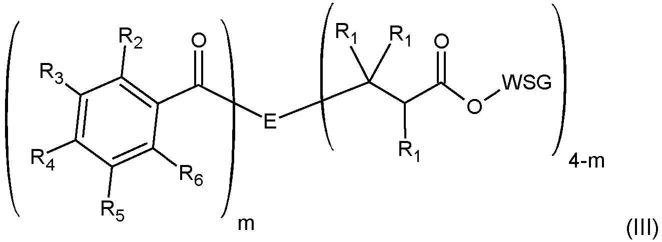 wherein E, R₁, R₂, R₃, R₄, R₅, R₆, WSG and m are defined as above.

In an embodiment, X represents independently from each other on each occurrence "-N(-H)-". In other words, the compound may be represented by the following general formula (IV): 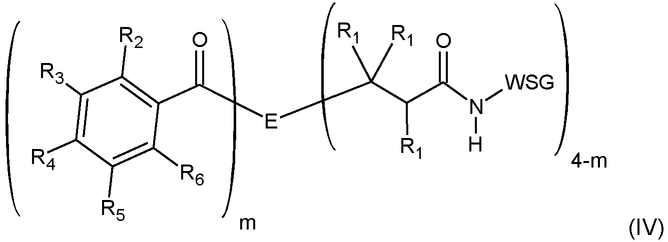 wherein E, R₁, R₂, R₃, R₄, R₅, R₆, WSG and m are defined as above.

In an embodiment, X represents independently from each other on each occurrence "-N(-WSG)-". In other words, the compound may be represented by the following general formula (V): 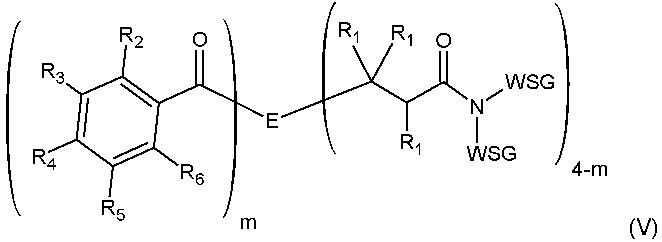 wherein E, R₁, R₂, R₃, R₄, R₅, R₆, WSG and m are defined as above.

In an embodiment, WSG represents - independently from each other on each occurrence - a carbohydrate, in particular a sugar derivative. Suitable examples thereof include glucose (e.g., glycosylation for enhanced solubility), maltose (higher solubility due to additional hydroxyl groups), mannose (which may be particularly suitable for targeted biological interactions), lactose (improves hydrophilicity), and cyclodextrins (which may form water-soluble inclusion complexes).

In an embodiment, WSG represents - independently from each other on each occurrence - an amino acid, in particular an amino acid having one or more hydrophilic groups in addition to the amino and carboxyl groups. Suitable examples thereof include lysine (contains an additional amine-terminated side chain), arginine (high hydrophilicity due to the guanidine group), glutamic acid and aspartic acid (carboxyl groups enhance water solubility), serine and threonine (hydrophilic hydroxyl groups).

In an embodiment, WSG represents - independently from each other on each occurrence - a polyethylene glycol (PEG). Suitable examples thereof include PEG-200 to PEG-600 (short-chain PEGs to improve water solubility), methoxy-PEG (mPEG) (stable, water-soluble derivatives), PEGylated carboxylic acids or amines (which may be suitable for targeted functionalization), and heterobifunctional PEGs (e.g., PEG-amines or PEG-carboxylates for covalent modifications).

In an embodiment, WSG represents - independently from each other on each occurrence - a water-soluble group selected from glucose, maltose, mannose, lactose, cyclodextrins, lysine, arginine, glutamic acid, aspartic acid, serine, threonine, PEG-200 to PEG-600, methoxy-PEG, PEGylated carboxylic acids or amines, and heterobifunctional PEGs.

In particular, polyethylene glycols have proven particularly suitable water-soluble groups for increasing the water solubility of the compound and exhibiting excellent stability both during synthesis and use (for instance as a photoinitiator in a resin composition). Polyethylene glycols having a number average molecular weight Mₙ of from 400 to 1500, in particular from 500 to 1300, such as from 600 to 1200, might be preferred.

In a preferred embodiment, m represents 3. Thus, the compound may be a tris-acyl germanium compound or a tris-acyl tin compound, preferably a tris-acyl germanium compound.

In another embodiment, m represents 2. Thus, the compound may be a bis-acyl germanium compound or a bis-acyl tin compound, preferably a bis-acyl germanium compound.

The compounds as described herein surprisingly have an absorption range for visible light which is clearly shifted towards longer wavelengths compared with structurally similar known photoinitiators. They thus allow the polymerization to be initiated with longer-wave light and make larger depths of cure possible. Moreover, the compounds as described herein are characterized by very high extinction coefficients of the absorption in the visible range. In low concentration they are therefore already effective as photoinitiators for polyreactions initiated by visible light. Moreover, the compounds as described herein are in particular characterized by a good solubility in polar solvents, such as water and alcohols, which is important in terms of environmental aspects and sustainability, and high stability in common resin systems. Still further, the compounds as described herein may be easily synthesized in a clean and cost-efficient manner, as discussed in further detail below.

In a second aspect, the present invention relates to a method of preparing (synthesizing) a compound, in particular a compound as described herein, the method comprising reacting a precursor compound represented by the following general formula (VI) with an α,β-unsaturated carbonyl compound represented by the following general formula (VII) under alkaline conditions (to yield a compound as described herein). 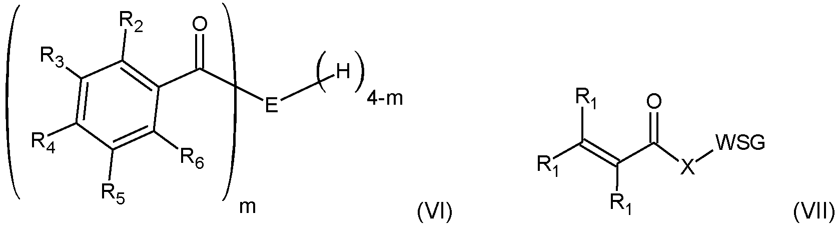 wherein
E represents Ge or Sn;
R₁ represents - independently from each other on each occurrence - hydrogen or an alkyl group;
R₂, R₃, R₄, R₅, R₆ represent - independently from each other on each occurrence - -H, -F, -Cl, -OR₇, -SR₇, -N(R₇)₂, -CF₃, -CN, -NO₂, -COOR₇, -CONHR₇, a branched, cyclic or preferably linear C₁₋₂₀ alkyl, C₂₋₂₀ alkenyl, C₁₋₂₀ alkyloxy or a C₂₋₂₀ alkenoxy moiety, optionally interrupted one or more times by O, S or -NR₇- and optionally substituted by one or more polymerizable groups and/or moieties R₇;
R₇ represents - independently from each other on each occurrence - hydrogen or a branched, cyclic or preferably linear C₁₋₂₀ alkyl or C₂₋₂₀ alkenyl moiety;
X represents - independently from each other on each occurrence - a single bond or a divalent group selected from the group consisting of -O-, -N(-H)- or -N(-WSG)-;
WSG represents - independently from each other on each occurrence - a water-soluble group selected from a carbohydrate, an amino acid, or a polyethylene glycol (PEG) group;
m represents 2 or 3.

The precursor compounds represented by the general formula (VI) may be prepared as described for instance in Drusgala M.; Paris M.; Maier J.; Fischer R. C.; Haas M. Synthesis and Characterization of New Counterion-Substituted Triacylgermenolates and Investigation of Selected Metal-Metal Exchange Reactions. Organometallics 2022, 41, 2170-2179, the entire content of which is incorporated herein by reference.

The α,β-unsaturated carbonyl compounds represented by the general formula (VII) are commercially available or may be prepared as readily known to a person skilled in the art.

In an embodiment, the precursor compound represented by the general formula (VI) may react with the α,β-unsaturated carbonyl compound represented by the general formula (VII) in a Michael addition, more specifically in case of E = Ge, a Germa-Michael addition. To this end, the precursor compound represented by the general formula (VI) and the α,β-unsaturated carbonyl compound represented by the general formula (VII) are mixed (preferably stirred) under alkaline conditions and optionally heated.

In an embodiment, the α,β-unsaturated carbonyl compound represented by the general formula (VII) is used in a substoichiometric molar amount relative to the precursor compound represented by the general formula (VI). For instance, in case of m = 3, the ratio of the molar amount of the α,β-unsaturated carbonyl compound represented by the general formula (VII) to the molar amount of the precursor compound represented by the general formula (VI) is less than 1, in particular from 0.9 to 0.99, such as about 0.95. Similarly, in case of m = 2, the ratio of the molar amount of the α,β-unsaturated carbonyl compound represented by the general formula (VII) to the molar amount of the precursor compound represented by the general formula (VI) is less than 2, in particular from 1.9 to 1.99, such as about 1.95. By taking this measure, undesired side reactions, for instance reactions of α,β-unsaturated carbonyl compounds represented by the general formula (VII) with each other, may significantly reduced.

In an embodiment, the alkaline conditions represent a pH value of from 8 to 14, in particular from 9 to 13, such as from 10 to 12.

In an embodiment, the alkaline conditions are obtained by an amine compound added to the reaction mixture. In particular, the amine compound may be added in an amount such that a pH value of from 8 to 14, in particular from 9 to 13, such as from 10 to 12 is obtained in the reaction mixture. The amine compound may be a primary amine, a secondary amine or preferably a tertiary amine. An example of the amine compound is 1,8-diazabicyclo[5.4.0]undec-7-ene, which has proven particularly suitable.

In an embodiment, the reaction (i.e. the step of reacting) is carried out in the presence of a solvent. It might be advantageous if the solvent (completely) dissolves the precursor compound represented by the general formula (VI) and/or the α,β-unsaturated carbonyl compound represented by the general formula (VII). It might however also be sufficient if the solvent (only) partially dissolves or disperses the precursor compound represented by the general formula (VI) and/or the α,β-unsaturated carbonyl compound represented by the general formula (VII). An example of the solvent includes dimethoxyethane (ethylene glycol dimethyl ether, DME), which has proven particularly suitable.

In an embodiment, the reaction (i.e. the step of reacting) is carried out under heating, in particular under reflux. For instance, the reaction mixture may be heated to a temperature of from 40 to 120°C, in particular 60 to 100 °C, such as 70 to 90 °C. As known to a person skilled in the art, under reflux, the reaction temperature is mainly determined by the type of solvent. However, the reaction may also be carried out at room temperature, i.e. without heating, depending on the type of reactants.

In an embodiment, the reaction (i.e. the step of reacting) is carried out in for 10 minutes to 24 hours, in particular for 30 minutes to 20 hours, such as from 1 to 18 hours.

In a third aspect, the present invention relates to a composition comprising a compound as described herein and at least one (photo)polymerizable monomer, oligomer and/or prepolymer.

In an embodiment, the at least one (photo)polymerizable monomer, oligomer and/or prepolymer is selected from the group consisting of mono- or multifunctional (meth)acrylates or a mixture thereof, preferably mono- or multifunctional methacrylates. The term "monofunctional (meth)acrylates", as used herein, in particular denotes compounds having one polymerizable (meth)acryl group, typically leading to linear or low-crosslinked polymers, whereas the term "multifunctional (meth)acrylates", as used herein, in particular denotes compounds having two or more, preferably 2 to 3, polymerizable (meth)acryl groups, allowing for obtaining highly crosslinked structures.

Suitable examples of monofunctional (meth)acrylates include:
- Methyl acrylate (MA) - Fast-reacting, used in copolymerization.
- Ethyl acrylate (EA) - Soft, flexible polymer films.
- Butyl acrylate (BA) - Enhances flexibility in coatings and adhesives.
- 2-Hydroxyethyl acrylate (HEA) - Provides hydroxyl functionality for crosslinking.
- 2-Hydroxypropyl methacrylate (HPMA) - Used in biocompatible hydrogels.
- Isobornyl acrylate (IBOA) - Improves hardness and thermal stability.
- Tetrahydrofurfuryl acrylate (THFA) - Enhances adhesion and water resistance.

Suitable examples of multifunctional (meth)acrylates include:
- Ethylene glycol diacrylate (EGDA) - Common crosslinker for rigid networks.
- Diethylene glycol diacrylate (DEGDA) - Provides flexibility in crosslinked systems.
- Trimethylolpropane triacrylate (TMPTA) - High crosslink density, used in UV-curable coatings.
- Pentaerythritol tetraacrylate (PETA) - Enhances mechanical strength and chemical resistance.
- Dipentaerythritol penta/hexaacrylate (DPEPA, DPHA) - Used in high-performance coatings.
- Bisphenol A ethoxylate diacrylate (BPA-EDA) - Improves thermal stability in coatings.
- Urethane dimethacrylate (UDMA) - Used in dental resins and biomedical applications.

In an embodiment, the at least one (photo)polymerizable monomer, oligomer and/or prepolymer comprises triethylene glycol dimethacrylate (TEGDMA), which is a difunctional methacrylate monomer commonly used in polymer and dental applications.

In an embodiment, the composition further comprises one or more additives. Suitable additives include fillers, in particular organic and/or preferably inorganic fillers, dyes or pigments, stabilizers, dispersing agents, chain transfer reagents, levelling agents, rheology modifiers, lubricants, ight absorbers, in particular UV absorbers, and defoaming additives. The fillers may be in fibrous or in particulate form, wherein particulate fillers are preferred.

In an embodiment, the composition further comprises one or more solvents. Suitable solvents include water, ethanol, isopropanol, acetone, ethyl acetate and mixtures thereof.

In an embodiment, the composition comprises:
(a) 0.001 to 3 wt.-%, preferably 0.001 to 1.0 wt.-% and particularly preferably 0.005 to 0.5 wt.-% of at least one compound of general formula (I),
(b) 1 to 99.9 wt.-%, preferably 5 to 95 wt.-% and particularly preferably 10 to 90 wt.-% of at least one radically polymerizable monomer, oligomer and/or prepolymer,
(c) 0 to 85 wt.-%, preferably 5 to 80 wt.-% and particularly preferably 10 to 75 wt.-% of one or more additives; and
(d) 0 to 70 wt.-%, preferably 0.1 to 60 wt.-% and particularly preferably 0.1 to 50 wt.-% of one or more solvents.

In an embodiment, the composition represents a dental composition, i.e. a composition to be used in dental appliances, such as dental adhesives, dental cements, dental primers, dental coating materials, dental filling composites, and the like.

In a fourth aspect, the present invention relates to the use of a compound as described herein as a photoinitiator.

The compounds as described herein are particularly suitable as photoinitiators for (photo)polymerization reactions, in particular as initiators for a polyaddition reaction and for a thiol-ene reaction and particularly for radical or cationic polymerization.

The term "photoinitiator", as used herein, in particular denotes a compound which can be activated by an energy-carrying activation beam (such as electromagnetic radiation), for instance upon irradiation therewith. Upon activation by an energy-carrying beam, the photoinitiator may in particular be converted into a radical thereof. Thus, the photoinitiator may be in particular a radical generating photoinitiator. The photoinitiator may be in particular a type I photoinitiator or a type II photoinitiator, preferably a type I photoinitiator.

In a fifth aspect, the present invention relates to a method of preparing polymers, the method comprising irradiating a composition (as described herein) comprising at least one (photo)polymerizable monomer, oligomer and/or prepolymer and a compound as described herein as a photoinitiator at a wavelength of from 320 to 470 nm.

In an embodiment, the method of preparing polymers may be a printing method, in particular a three-dimensional (3D) printing method. The term "three-dimensional printing method", as used herein, in particular denotes that the product of the printing method extends in three directions (for example, length, width and height). Thus, the product of a three-dimensional printing method may be in particular a three-dimensional object. The three-dimensional printing method may be in particular any one selected from the group consisting of stereolithography (SLA), two-photon absorption (TPA) polymerization, digital light processing (DLP), reactive laser sintering (RLS), solid ground curing (SGC), multi jet modeling (MJM) or a combination thereof. In view of its high resolution, stereolithography (SLA) may be preferred.

It might be advantageous to carry out the irradiation step under an inert gas atmosphere (such as under a N₂, CO₂, or a noble gas, in particular Ar, atmosphere), while it is also possible to carry out this step under ambient gas atmosphere, such as air, or even under (substantially) pure oxygen.

The duration of the irradiation step is not particularly limited, and may be appropriately selected by a person skilled in the art, depending in particular on the type of the (printing) method and the components of the resin composition (in particular their reactivity). For instance, suitable times (durations) for irradiation may be from 1 ms to 1 h, in particular from 1 s to 1 min.

In an embodiment, the composition is irradiated at a wavelength of from 330 to 450 nm, in particular 340 to 440 nm, such as 350 to 430 nm.

In an embodiment, the at least one (photo)polymerizable monomer, oligomer and/or prepolymer is selected from the group consisting of mono- or multifunctional (meth)acrylates or a mixture thereof, preferably mono- or multifunctional methacrylates.

In a sixth aspect, the present invention relates to the use of a compound as described herein as a phototherapeutic. In other words, the present invention relates a compound as described herein for use as a phototherapeutic.

The term "phototherapeutic", as used herein, in particular denotes a compound which can be activated by an energy-carrying activation beam (such as electromagnetic radiation), for instance upon irradiation therewith, and which may be used in a therapeutic method, in particular which may contribute either directly or indirectly to a therapeutic effect after activation by irradiation.

Recently, advancements in cancer therapy have focused on the usage of light-based technologies. These novel therapies often leverage light to precisely target cancer cells while minimizing damage to surrounding healthy tissue. The benefit of such light-activated therapies is demonstrated by the success of photodynamic therapy (PDT), where photosensitizer generates reactive oxygen species (i.e. singlet oxygen, hydroxyl radical, peroxides and superoxide). These molecules finally induce oxidative stress and cell death (S. Kwiatkowski, B. Knap, D. Przystupski, J. Saczko, E. K 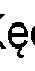 dzierska, K. Knap-Czop, J. Kotlińska, O. Michel, K. Kotowski, J. Kulbacka, Biomedicine & pharmacotherapy = Biomedecine & pharmacotherapie 2018, 106, 1098-1107; B. M. Vickerman, E. M. Zywot, T. K. Tarrant, D. S. Lawrence, Nature reviews. Chemistry 2021, 5, 816-834).

However, as the photosensitizers used in the state-of-the-art PDT are not photo-cleaved upon activation they remain permanently active under irradiation until degraded or excreted. Therefore, a main disadvantage of PDT is a light sensitivity of the treated patient, which can last over weeks (D. E. J. G. J. Dolmans, D. Fukumura, R. K. Jain, Nature reviews. Cancer 2003, 3, 380-387). Recently, Möckel et al. pioneered in the usage of water-soluble bisacylphosphine oxides (BAPOs) as novel PDT (A. Beil, F. A. Steudel, C. Bräuchle, H. Grützmacher, L. Möckl, Scientific reports 2019, 9, 6003; K. Almahayni, J. B. Salvador, R. Conti, A. Widera, M. Spiekermann, D. Wehner, H. Grützmacher, L. Möckl, ACS chemical biology 2024.). This compound class is originally known as very effective type I photoinitiators for a variety of applications (. A. Green, Industrial Photoinitiators, CRC Press, 2010; J.-P. Fouassier, J. Lalevée, Photoinitiators, Wiley, 2021; S. M. Miller, S. Schlögl, T. Wiesner, M. Haas, T. Griesser, ChemPhotoChem 2022, 6). These BAPOs are photo-cleaved upon irradiation and, within the activation process, transformed into an inactive form. Therefore, with a sufficient light dose, the whole amount of drug can be activated at the desired area with no side effects after the treatment. The effectiveness of BAPOs directly correlates with the administered dose since the number of radicals being produced after irradiation is limited for every molecule (see Scheme 1, state-of-the-art). This advantage towards PDT is even more favorable, since BAPOs can be cleaved at the desired area. However, BAPOs have two major disadvantages, which prevented the clinical launch so far:
1. BAPOs require UV or blue light to be activated. Consequently, this energy rich light cannot penetrate the human skin to a certain amount in order to act as potent PDT.
2. BAPOs and its degradation products have been described as toxic, which further limits their applications in the medical field (M. Popal, J. Volk, G. Leyhausen, W. Geurtsen, Dental materials : official publication of the Academy of Dental Materials 2018, 34, 1783-1796; b) B. Zeng, Z. Cai, J. Lalevée, Q. Yang, H. Lai, P. Xiao, J. Liu, F. Xing, Toxicology in vitro : an international journal published in association with BIBRA 2021, 72, 105103).

In the last decade, acyl metalloids (mainly germanium- and tin-based) have evolved as potent type I photoinitiators especially for medical application (Ganster, U. K. Fischer, N. Moszner, R. Liska, Macromol. Rapid Commun. 2008, 29, 57-62; D. Neshchadin, A. Rosspeintner, M. Griesser, B. Lang, S. Mosquera-Vazquez, E. Vauthey, V. Gorelik, R. Liska, C. Hametner, B. Ganster et al., Journal of the American Chemical Society 2013, 135, 17314-17321; J. Radebner, A. Eibel, M. Leypold, C. Gorsche, L. Schuh, R. Fischer, A. Torvisco, D. Neshchadin, R. Geier, N. Moszner et al., Angewandte Chemie (International ed. in English) 2017, 56, 3103-3107; H. Stueger, M. Haas, J. Radebner, A. Eibel, G. Gescheidt, Chemistry (Weinheim an der Bergstrasse, Germany) 2018; P. Jöckle, J. Radebner, M. Haas, I. Lamparth, H. Stueger, N. Moszner, A.-N. Unterreiner, C. Barner-Kowollik, ACS Macro Lett. 2018, 7, 132-136; J. Radebner, A. Eibel, M. Leypold, N. Jungwirth, T. Pickl, A. Torvisco, R. Fischer, U. K. Fischer, N. Moszner, G. Gescheidt et al., Chemistry (Weinheim an der Bergstrasse, Germany) 2018, 24, 8281-8285; J. Maier, S. M. Müller, A. Torvisco, G. Glotz, R. C. Fischer, T. Griesser, A.-M. Kelterer, M. Haas, ChemPhotoChem 2022, 6; M. Drusgala, P. Frühwirt, G. Glotz, K. Hogrefe, A. Torvisco, R. Fischer, H. M. R. Wilkening, A.-M. Kelterer, G. Gescheidt, M. Haas, Angew. Chem. Int. Ed. 2021). Compared to phosphorus-based Pls, these initiators have a lower toxicity as well as a significant bathochromic shift of the longest wavelength absorption. However, no acyl metalloids as described in the literature were water soluble so far.

The compounds according to the general formula (I) as described herein provide for the first time water-soluble acyl metalloids that may be used as a phototherapeutic. In particular, the compounds according to the general formula (I) are characterized by:
- cleavage upon irradiation within the activation process, thereby transformed into an inactive form, unlike photosensitizers, thereby avoiding light sensitivity of the treated patient over months
- bathochromic shift of the longest wavelength absorption compared to phosphorus-based Pls, thereby better penetration of the human skin in order to act as potent PDT
- lower toxicity compared to phosphorus-based Pls, which is clearly advantageous in the treatment of patients
- water solubility, unlike the hitherto known acyl metalloids, which is crucial for use as a phototherapeutic
- surface-active properties, which allow the compounds to pass through membranes or cell walls and thus to reach the target site.

Thus, the compounds according to the general formula (I) as described herein combine several very important characteristics for a phototherapeutic, thereby rendering them promising candidates for use as a phototherapeutic.

In an embodiment, the compound as described herein is used as a phototherapeutic in the treatment of at least one disorder or disease selected from cancer, a viral infection, an eye disease, wound healing and a skin disease.

The present invention is further described by the following examples, which are solely for the purpose of illustrating specific embodiments, and are not construed as limiting the scope of the invention in any way.

### Examples

### Example 1: Polyethylene glycol with terminal tris(2,4,6-trimethylbenzoyl)germane

300 mg of the tris(2,4,6-trimethylbenzoyl)germane (prepared as described in Drusgala M.; Paris M.; Maier J.; Fischer R. C.; Haas M. Synthesis and Characterization of New Counterion-Substituted Triacylgermenolates and Investigation of Selected Metal-Metal Exchange Reactions. Organometallics 2022, 41, 2170-2179) (0.58 mmol; 1.00 eq.) and 525 mg of poly(ethylene glycol) methyl ether methacrylate (Mn = 950 Da) (0.55 mmol; 0.95 eq.) are dissolved in 20 mL of dimethoxyethane. After the addition of 60 µL of a 1M solution of 1,8-diazabicyclo[5.4.0]undec-7-ene in THF (0.06 mmol; 0.1 eq.) the reaction mixture is refluxed for 17 hours. Then all volatiles are removed, the yellow oily remaining residue is dissolved in acetone and recrystallized at -80 °C. 774 mg of the target product were isolated via filtration as a yellow solid in a yield of 96 %.

**¹³C-NMR** (CDCl₃, TMS, ppm): 236.56 (C=O), 176.45 (C=O), 141.8 (Mes-C4), 139.32 (Mes-C1), 132.75 (Mes-C2), 128.78 (Mes-C3), 71.96, 70.63, 70.60, 70.55, 69.12, 63.63, (CH₂-O), 59.06 (O-CH₃), 35.16 (CH-CO), 21.63 (Ge-CH₂), 21.14 (Aryl-CH₃), 20.96 (CH-CH₃), 19.17 (Aryl-CH₃). **¹H-NMR** (CDCl₃, TMS, ppm): 6.64 (s, 6H, Mes-H), 4.07-4.15, 3.59-3.62, 3.50-3.52 (CH₂-O), 3.34 (s, 3H, O-CH₃), 2.49-2.58 (m, J = 17.5 Hz, 1 H, CH-CH₃), 2.21 (s, 9H, Mes-CH₃), 2.03 (s, 18H, Mes-C*H*₃), 1.85-1.91 (dd, J = 14.0, 7.0 Hz, 1H, Ge-CH₂), 1.31-1.36 (dd, J = 14.1, 6.4 Hz, 1H, Ge-C*H*₂), 0.96-0.98 (d, J = 7.1 Hz, 3H, CH-CH₃). **UV-Vis:** λ [nm] (ε [L mol⁻¹ cm⁻¹]) = 403 (824), 383 (1088), 369 (855). **IR** (neat): v(C-H) 2863, v(C=O) = 1731, 1698, 1636, 1609, v(C-O-C) 1139, 1102, 1037.

While the present invention has been described in detail by way of specific embodiments and examples, the invention is not limited thereto and various alterations and modifications are possible, without departing from the scope of the invention.

## Claims

1. A compound represented by the following general formula (I): 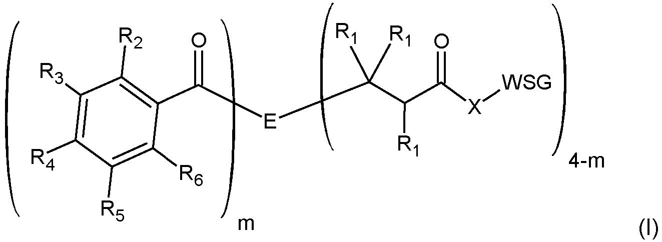 wherein
E represents Ge or Sn;
R₁ represents - independently from each other on each occurrence - hydrogen or an alkyl group;
R₂, R₃, R₄, R₅, R₆ represent - independently from each other on each occurrence - -H, -F, -Cl, -OR₇, -SR₇, -N(R₇)₂, -CF₃, -CN, -NO₂, -COOR₇, -CONHR₇, a branched, cyclic or preferably linear C₁₋₂₀ alkyl, C₂₋₂₀ alkenyl, C₁₋₂₀ alkyloxy or a C₂₋₂₀ alkenoxy moiety, optionally interrupted one or more times by O, S or -NR₇- and optionally substituted by one or more polymerizable groups and/or moieties R₇;
R₇ represents - independently from each other on each occurrence - hydrogen or a branched, cyclic or preferably linear C₁₋₂₀ alkyl or C₂₋₂₀ alkenyl moiety;
X represents - independently from each other on each occurrence - a single bond or a divalent group selected from the group consisting of -O-, -N(-H)- or -N(-WSG)-;
WSG represents - independently from each other on each occurrence - a water-soluble group selected from a carbohydrate, an amino acid, or a polyethylene glycol (PEG) group;
m represents 2 or 3.

2. The compound according to claim 1, wherein E represents Ge.

3. The compound according to claim 1 or 2, wherein m represents 3.

4. The compound according to any one of the preceding claims, wherein R₁ represents - independently from each other on each occurrence - hydrogen or a methyl group.

5. The compound according to any one of the preceding claims, wherein the compound is represented by one of the following general formulae (II) and (III): 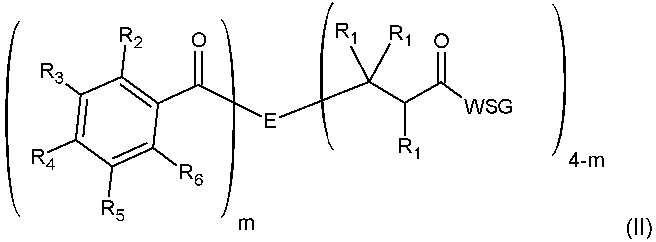 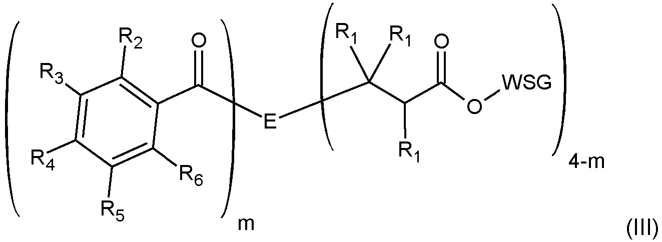 wherein E, R₁, R₂, R₃, R₄, R₅, R₆, WSG and m are defined as above.

6. The compound according to any one of claims 1 to 4, wherein the compound is represented by one of the following general formulae (IV) and (V): 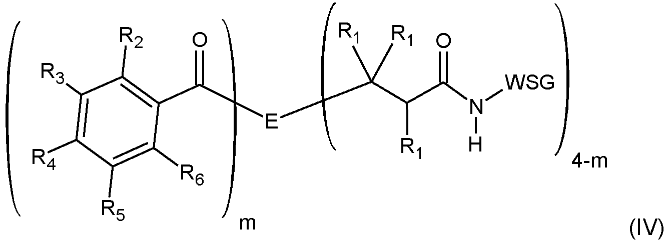 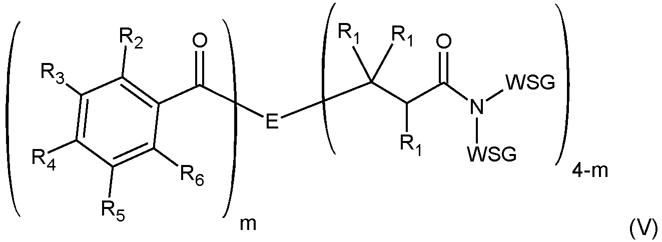 wherein E, R₁, R₂, R₃, R₄, R₅, R₆, WSG and m are defined as above.

7. The compound according to any one of the preceding claims, wherein WSG represents - independently from each other on each occurrence - a water-soluble group selected from glucose, maltose, mannose, lactose, cyclodextrins, lysine, arginine, glutamic acid, aspartic acid, serine, threonine, PEG-200 to PEG-600, methoxy-PEG, PEGylated carboxylic acids or amines, and heterobifunctional PEGs.

8. A method of preparing a compound, in particular a compound according to any one of claims 1 to 7, the method comprising:
reacting a precursor compound represented by the following general formula (VI) with an α,β-unsaturated carbonyl compound represented by the following general formula (VII) under alkaline conditions, 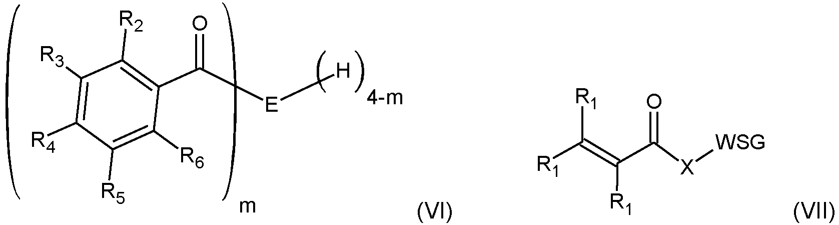
wherein
E represents Ge or Sn;
R₁ represents - independently from each other on each occurrence - hydrogen or an alkyl group;
R₂, R₃, R₄, R₅, R₆ represent - independently from each other on each occurrence - -H, -F, -Cl, -OR₇, -SR₇, -N(R₇)₂, -CF₃, -CN, -NO₂, -COOR₇, -CONHR₇, a branched, cyclic or preferably linear C₁₋₂₀ alkyl, C₂₋₂₀ alkenyl, C₁₋₂₀ alkyloxy or a C₂₋₂₀ alkenoxy moiety, optionally interrupted one or more times by O, S or -NR₇- and optionally substituted by one or more polymerizable groups and/or moieties R₇;
R₇ represents - independently from each other on each occurrence - hydrogen or a branched, cyclic or preferably linear C₁₋₂₀ alkyl or C₂₋₂₀ alkenyl moiety;
X represents - independently from each other on each occurrence - a single bond or a divalent group selected from the group consisting of -O-, -N(-H)- or -N(-WSG)-;
WSG represents - independently from each other on each occurrence - a water-soluble group selected from a carbohydrate, an amino acid, or a polyethylene glycol (PEG) group;
m represents 2 or 3.

9. The method according to claim 8,
wherein the alkaline conditions represent a pH value of from 8 to 14; and/or
wherein the alkaline conditions are obtained by an amine compound.

10. The method according to claim 8 or 9,
wherein the reaction is carried out in the presence of a solvent; and/or
wherein the reaction is carried out under heating, in particular under reflux; and/or
wherein the reaction is carried out for 10 minutes to 24 hours.

11. A composition comprising a compound according to any one of claims 1 to 7 and at least one polymerizable monomer, oligomer and/or prepolymer.

12. The composition according to claim 11, wherein the at least one polymerizable monomer, oligomer and/or prepolymer is selected from the group consisting of mono- or multifunctional (meth)acrylates or a mixture thereof.

13. Use of a compound according to any one of claims 1 to 7 as a photoinitiator.

14. A method of preparing polymers, the method comprising:
irradiating a composition comprising at least one photopolymerizable monomer, oligomer and/or prepolymer and a compound according to any one of claims 1 to 7 as a photoinitiator at a wavelength of from 320 to 470 nm.

15. A compound according to any one of claims 1 to 7 for use as a phototherapeutic.
